# EUROPEAN PATENT APPLICATION

(11) **EP 4 734 254 A1**
(43) Date of publication of application: **29.04.2026**
(21) Application number: 24869652.8
(22) Date of filing: 03.04.2024
(51) Int. Cl.: H01M 50/244, H01M 50/298, H02J 3/32

(54) **ENERGY STORAGE SYSTEM AND MICROGRID SYSTEM**

(30) Priority: 28.09.2023 CN 202322652243 U
(71) Applicant: Contemporary Amperex Technology Co., Limited, Ningde, Fujian 352100 (CN)
(72) Inventor: ZHANG, Xuefang, Ningde, Fujian 352100 (CN); HE, Shuangjiang, Ningde, Fujian 352100 (CN); SU, Haibin, Ningde, Fujian 352100 (CN); LI, Zhonghong, Ningde, Fujian 352100 (CN); XU, Jinmei, Ningde, Fujian 352100 (CN); LUO, Guangsheng, Ningde, Fujian 352100 (CN); WU, Kai, Ningde, Fujian 352100 (CN)
(74) Representative: Lorenz Seidler Gossel Part. mbB
(86) International application number: PCT/CN2024/085808
(87) International publication number: WO 2025/066083

(57) **Abstract**

Embodiments of this application provide an energy storage system and a microgrid system. The energy storage system includes: one or more battery clusters, where the battery cluster includes a plurality of battery cells, and a dimension of the battery cluster along a first direction is greater than a dimension of the battery cluster along a second direction; and an enclosure configured to accommodate the battery clusters, a dimension of the enclosure along the first direction being smaller than a dimension of the enclosure along the second direction; where along the first direction, the dimension of the enclosure matches the dimension of the battery cluster, such that the enclosure is configured to accommodate one row of battery clusters along the first direction, the first direction is perpendicular to the second direction, and both the first direction and the second direction are perpendicular to a height direction of the enclosure. The energy storage system and the microgrid system according to embodiments of this application can improve the space utilization of the enclosure of the energy storage system.

## Description

### CROSS-REFERENCE TO RELATED APPLICATIONS

This application claims priority to Chinese Utility Model Application No. 202322652243.0, filed with the China Patent Office on September 28, 2023 and entitled "ENERGY STORAGE SYSTEM AND MICROGRID SYSTEM," which is incorporated herein by reference in its entirety.

### TECHNICAL FIELD

This application relates to the field of energy storage technologies, and more particularly, to an energy storage system and a microgrid system.

### BACKGROUND

With the continuous development of new energy technologies, an increasing number of energy storage systems have been integrated into power grids. With the integration of energy storage systems into power grids, the random and fluctuating energy from renewable energy systems, such as wind power and photovoltaic systems, can be smoothly transmitted to the power grids, thereby reducing the impact of power fluctuations from renewable energy systems on the power grids and enhancing the stability and reliability of the power grids.

Currently, energy storage systems are predominantly containerized energy storage systems. Containerized energy storage systems have low space utilization, resulting in relatively large footprints, inconvenient installation and transportation, and lower energy density, which significantly limits the applications of the energy storage systems.

### SUMMARY

Embodiments of this application provide an energy storage system and a microgrid system, so as to improve the space utilization of the enclosure of the energy storage system.

According to a first aspect, an energy storage system is provided, including: one or more battery clusters, where the battery cluster includes a plurality of battery cells, and a dimension of the battery cluster along a first direction is greater than a dimension of the battery cluster along a second direction; and an enclosure configured to accommodate the battery clusters, a dimension of the enclosure along the first direction being smaller than a dimension of the enclosure along the second direction; where along the first direction, the dimension of the enclosure matches the dimension of the battery cluster, such that the enclosure is configured to accommodate one row of battery clusters along the first direction, the first direction is perpendicular to the second direction, and both the first direction and the second direction are perpendicular to a height direction of the enclosure.

In the embodiments of this application, along the first direction, the dimension of the enclosure is configured to match the dimension of the battery cluster, allowing the enclosure to accommodate one row of battery clusters along the first direction. In addition, the enclosure can accommodate only one row of elongated battery clusters along the first direction by arranging a long side of the battery cluster parallel to a short side of the enclosure, thereby improving the space utilization of the enclosure.

In a possible implementation, the battery cluster includes one or more battery modules stacked along the height direction, each battery module including one or more battery cells.

In the embodiments of this application, a battery cluster including one battery module or a plurality of battery modules stacked along the height direction is provided, which allows the enclosure to accommodate one row of battery modules along the first direction, with a long side of the battery module being parallel to a short side of the enclosure, thereby allowing the enclosure to accommodate exactly one row of elongated battery modules along the first direction, improving the space utilization of the enclosure.

In a possible implementation, the battery cells in the battery module are connected in series.

In the embodiments of this application, the requirement for the overcurrent capacity of electrical components in the battery module can be lowered by connecting the battery cells in the battery module in series while the number of battery cells in the battery module can be increased.

In a possible implementation, the battery module further includes a slave control unit, where the slave control unit is connected to the battery cells of the battery module and configured to collect state information of the battery cells in the battery module, the state information including one or more of current information, voltage information, power information, or state of charge SOC information.

In the embodiments of this application, one or more state information of the battery cells such as current information, voltage information, power information, or SOC information are collected, then the state information of the battery module, battery cluster, or energy storage system can be determined based on the state information of the battery cells, thereby enabling reasonable control of the charging and discharging processes of the energy storage system, enhancing the performance and lifespan of the energy storage system.

In a possible implementation, the battery module includes 104 battery cells.

In the embodiments of this application, the provision of 104 battery cells in the battery module increases the number of battery cells in the battery module.

In a possible implementation, the battery module includes two slave control units, where the two slave control units are configured to respectively collect state information of a first group of battery cells and a second group of battery cells among the 104 battery cells, and the number of battery cells in the first group or the second group does not exceed 56.

In the embodiments of this application, the state information of the battery cells in the battery module can be comprehensively and accurately collected by providing two slave control units in the battery module including 104 battery cells, thereby enabling precise control of the charging and discharging of the energy storage system, improving the performance and lifespan of the energy storage system.

In a possible implementation, the battery cluster further includes a master control box, the master control box being configured for energy transmission of the battery cluster.

In the embodiments of this application, the master control box provided in the battery cluster may be configured to house electrical components of the battery cluster, facilitating maintenance and management of the electrical components in the battery cluster.

In a possible implementation, the enclosure includes a plurality of compartments arranged along the second direction, where the plurality of compartments include a first compartment, the first compartment being configured to accommodate at least one of the plurality of battery clusters.

In the embodiments of this application, a plurality of compartments arranged along the second direction are provided in the enclosure, and at least one battery cluster can be accommodated in one of the plurality of compartments, achieving reasonable allocation of space within the enclosure and improving the space utilization of the enclosure.

In a possible implementation, the first compartment includes a plurality of sub-compartments, where the plurality of sub-compartments are stacked along the height direction and respectively configured to accommodate battery modules and the master control box of the at least one battery cluster.

In the embodiments of this application, a plurality of sub-compartments stacked along the height direction are provided in the first compartment and configured to accommodate battery modules and the master control box of at least one battery cluster, achieving reasonable utilization of space within the first compartment, improving the space utilization of the first compartment, and thereby improving the space utilization of the enclosure.

In a possible implementation, external output panels of the battery modules of the at least one battery cluster face a first side of the first direction, where the number of battery modules in the at least one battery cluster is greater than or equal to two.

In the embodiments of this application, installation and maintenance of the battery cluster are facilitated by configuring the external output panels of the battery modules in the first compartment to face the same direction, improving the efficiency of installation and maintenance of the battery cluster, while also enabling reasonable utilization of the space of the enclosure, improving the space utilization of the enclosure.

In a possible implementation, the at least one battery cluster includes one master control box, where one end of the master control box is connected to the battery modules of the at least one battery cluster, and the other end of the master control box is connected to a bus.

In the embodiments of this application, the at least one battery cluster in the first compartment may include one master control box, and the master control box is configured for energy transmission of the at least one battery cluster, so that the space occupied by the master control box in the first compartment can be reduced, thereby improving the space utilization of the enclosure or reducing the volume of the enclosure.

In a possible implementation, one battery cluster among the at least one battery cluster includes one master control box, where one end of the one master control box is connected to the battery modules of the one battery cluster, and the other end of the one master control box is connected to a bus.

In the embodiments of this application, each battery cluster includes one master control box, so energy transmission of each battery cluster can be flexibly achieved while facilitating installation and maintenance of each battery cluster in the first compartment, improving the efficiency of installation and maintenance of the battery cluster.

In a possible implementation, a door on the first side is provided at a portion of the enclosure corresponding to the first compartment.

In the embodiments of this application, a door is provided at the portion of the enclosure corresponding to the first compartment on the side of the external output panels of the battery modules of the at least one battery cluster to facilitate installation and maintenance of the battery cluster, improving the efficiency of installation and maintenance of the battery cluster.

In a possible implementation, the external output panels of the battery modules of the at least one battery cluster face two sides of the first direction, where the external output panels of the battery modules of a same battery cluster face a same direction, and the number of the at least one battery cluster is greater than or equal to two.

In the embodiments of this application, the orientation of the battery modules in the first compartment can be flexibly arranged by configuring the output panels of the battery modules in the first compartment to face two sides of the first direction, while also facilitating installation and maintenance of each battery cluster in the first compartment, improving the efficiency of installation and maintenance of the battery cluster.

In a possible implementation, one battery cluster among the at least one battery cluster includes one master control box, where one end of the one master control box is connected to the battery modules of the one battery cluster, and the other end of the one master control box is connected to a bus.

In the embodiments of this application, each battery cluster in the first compartment may include one master control box, and the one master control box may be configured for energy transmission of the one battery cluster, facilitating installation and maintenance of each battery cluster in the first compartment, and improving the efficiency of installation and maintenance of the battery cluster.

In a possible implementation, doors are provided at portions of the enclosure corresponding to the first compartment on two sides of the first direction.

In the embodiments of this application, doors are provided at portions of the enclosure corresponding to the first compartment on two sides of the first direction, facilitating installation and maintenance of each battery cluster in the first compartment, and improving the efficiency of installation and maintenance of the battery cluster.

In a possible implementation, the external output panels of the master control box and the battery modules of one battery cluster among the at least one battery cluster face a same direction.

In the embodiments of this application, the external output panels of the master control box and the battery modules of one battery cluster are configured to face a same direction, facilitating installation and maintenance of the battery cluster while improving the space utilization of the enclosure.

In a possible implementation, the energy storage system includes eight battery clusters, the enclosure includes four compartments arranged along the second direction, and one of the four compartments is configured to accommodate two of the eight battery clusters.

In the embodiments of this application, four compartments arranged along the second direction are provided in the enclosure, and at least two battery clusters can be accommodated in one of the four compartments, achieving reasonable allocation of space within the enclosure and improving the space utilization of the enclosure.

In a possible implementation, each of the eight battery clusters includes four battery modules, one compartment includes nine sub-compartments stacked along the height direction, the lowermost sub-compartment of the nine sub-compartments is configured to accommodate the master control boxes of two battery clusters, and the remaining sub-compartments of the nine sub-compartments are respectively configured to accommodate the eight battery modules of the two battery clusters, where battery modules accommodated in adjacent sub-compartments belong to different battery clusters.

In the embodiments of this application, reasonable utilization of space within the compartment is achieved by providing nine sub-compartments stacked along the height direction in the first compartment, configured to accommodate the battery modules and the master control boxes of two battery clusters, improving the space utilization of the compartment, and thereby improving the space utilization of the enclosure.

In a possible implementation, the external output panels of the battery modules of the two battery clusters face a side of the first direction, the two battery clusters include one master control box, the external output panels of the battery modules of the two battery clusters and the external output panel of the one master control box face a same direction, and the one master control box is configured for energy transmission of the two battery clusters.

In the embodiments of this application, in one compartment, the external output panels of the battery modules and the master control box of the two battery clusters are configured to face the same direction, facilitating installation and maintenance of the battery clusters in one compartment and improving the efficiency of installation and maintenance of the battery clusters, while also enabling reasonable utilization of the enclosure space, improving the space utilization of the enclosure.

In a possible implementation, the external output panels of the battery modules of the two battery clusters face two sides of the first direction, each of the two battery clusters includes one master control box, and the external output panels of the battery modules and the master control box of each of the two battery clusters face a same direction.

In the embodiments of this application, the output panels of the battery modules in one compartment are configured to face two sides of the first direction, which allows flexible arrangement of the orientation of the battery modules in the compartment while facilitating installation and maintenance of each battery cluster in the compartment, improving the efficiency of installation and maintenance of the battery cluster.

In a possible implementation, the energy storage system further includes one or more of the following: a thermal management apparatus configured to regulate a temperature of the energy storage system; a fire protection apparatus configured to perform detection, alarm, or fire suppression for the energy storage system; and a power distribution apparatus configured to distribute power to electrical equipment of the energy storage system; where one or more of the thermal management apparatus, the fire protection apparatus, or the power distribution apparatus are disposed on one side of the enclosure along the second direction.

In the embodiments of this application, one or more of the thermal management apparatus, the fire protection apparatus, and the power distribution apparatus are disposed on one side of the enclosure along the second direction, improving the space utilization of the enclosure.

In a possible implementation, the battery cluster further includes a master control unit, one end of the master control unit being connected to the slave control unit and configured to communicate with the slave control unit.

In the embodiments of this application, the master control unit is connected to the slave control unit, allowing acquisition of state information of the battery cells in the battery cluster to accurately determine the state information of the battery cluster.

In a possible implementation, the energy storage system further includes: a main control unit, the main control unit being connected to the master control unit and configured to communicate with the master control unit.

In the embodiments of this application, the main control unit is connected to the master control unit, allowing acquisition of state information of the battery clusters in the energy storage system to determine the state information of the energy storage system, thereby allowing reasonable control of the charging and discharging processes of the energy storage system.

According to a second aspect, a microgrid system is provided, including the energy storage system according to the first aspect or any embodiment thereof as described above.

### BRIEF DESCRIPTION OF DRAWINGS

FIG. 1 is a schematic structural diagram of an energy storage system according to embodiments of this application.
FIG. 2 is a schematic structural diagram of a battery cluster according to embodiments of this application.
FIG. 3 is an architectural diagram of a battery cluster according to embodiments of this application.
FIG. 4 is another schematic structural diagram of a battery cluster according to embodiments of this application.
FIG. 5 is a schematic structural diagram of an energy storage system according to embodiments of this application.
FIG. 6 is a schematic diagram of a first compartment according to embodiments of this application.
FIG. 7 is an architectural diagram of an energy storage system according to embodiments of this application.
FIG. 8 is a schematic structural diagram of an energy storage system according to embodiments of this application.
FIG. 9 is another schematic diagram of a first compartment according to embodiments of this application.
FIG. 10 is an architectural diagram of an energy storage system according to embodiments of this application.
FIG. 11 is a schematic structural diagram of an energy storage system according to embodiments of this application.
FIG. 12 is a schematic structural diagram of an energy storage system according to embodiments of this application.
FIG. 13 is a schematic diagram of signal flow in an energy storage system according to embodiments of this application.
FIG. 14 is a schematic block diagram of a microgrid system according to embodiments of this application.

### DESCRIPTION OF EMBODIMENTS

The embodiments of this application are described in further detail below with reference to the accompanying drawings and embodiments. The detailed descriptions and drawings of the following embodiments are provided to illustrate the principles of this application by way of example, but are not intended to limit the scope of this application, which is not limited to the described embodiments.

In the description of this application, it should be noted that terms indicating orientation or positional relationships, such as "inner" and "outer," are used for convenience of description and simplification, and do not indicate or imply that the referenced apparatuses or elements must have a specific orientation, be constructed, or operate in a specific orientation, and thus should not be construed as limiting this application. The directional terms appearing in the following description refer to the directions shown in the drawings and do not limit the specific structure of this application. In the embodiments of this application, "vertical" does not mean strictly vertical but is within an allowable range of error.

In the description of the embodiments of this application, technical terms such as "first" and "second" are used only to distinguish different objects and should not be construed as indicating or implying relative importance or implying the number, specific order, or primary-secondary relationship of the indicated technical features. In the description of the embodiments of this application, "plurality" means two or more, unless explicitly and specifically defined otherwise.

In the description of this application, it should also be noted that, unless explicitly specified and limited otherwise, the terms "connected" and "connection" should be understood in a broad sense, for example, as electrical connection, mechanical connection, or communication connection; as fixed connection, detachable connection, or integral connection; or as direct connection or indirect connection through an intermediate medium. For those skilled in the art, the specific meanings of the above terms in this application can be understood based on specific circumstances.

Reference to an "embodiment" herein means that a particular feature, structure, or characteristic described in connection with the embodiment may be included in at least one embodiment of this application. The appearances of the term "embodiment" in various places in the specification do not necessarily refer to the same embodiment or to an independent or alternative embodiment that is mutually exclusive of other embodiments. Those skilled in the art explicitly and implicitly understand that the embodiments described herein may be combined with other embodiments.

With the continuous development of new energy technologies, an increasing number of energy storage systems have been integrated into power grids. With the integration of energy storage systems into power grids, the random and fluctuating energy from renewable energy systems, such as wind power and photovoltaic systems, can be smoothly transmitted to the power grids, thereby reducing the impact of power fluctuations from renewable energy systems on the power grids and enhancing the stability and reliability of the power grids.

Currently, energy storage systems are predominantly containerized energy storage systems. Containerized energy storage systems have low space utilization, resulting in relatively large footprints, inconvenient installation and transportation, and lower energy density, which significantly limits the applications of the energy storage systems.

In view of this, this application provides an energy storage system and a microgrid system. The energy storage system includes: one or more battery clusters, where the battery cluster includes a plurality of battery cells, and a dimension of the battery cluster along a first direction is greater than a dimension of the battery cluster along a second direction; an enclosure configured to accommodate the battery clusters, a dimension of the enclosure along the first direction being smaller than a dimension of the enclosure along the second direction; where along the first direction, the dimension of the enclosure matches the dimension of the battery cluster, such that the enclosure is configured to accommodate one row of battery clusters along the first direction, the first direction is perpendicular to the second direction, and both the first direction and the second direction are perpendicular to a height direction of the enclosure.

In the embodiments of this application, along the first direction, the dimension of the enclosure is configured to match the dimension of the battery cluster, allowing the enclosure to accommodate one row of battery clusters along the first direction. In addition, the enclosure can accommodate only one row of elongated battery clusters along the first direction by arranging a long side of the battery cluster parallel to a short side of the enclosure, thereby improving the space utilization of the enclosure.

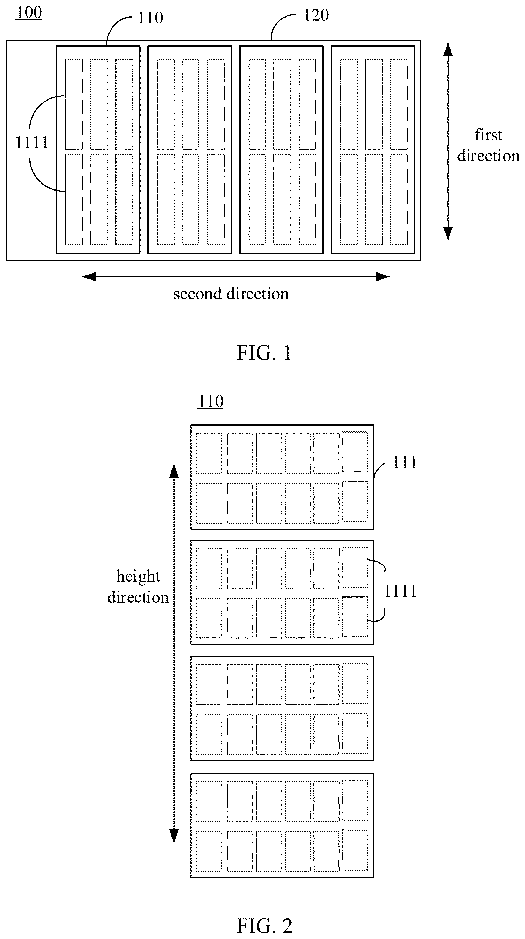

FIG. 1 is a schematic structural diagram of an energy storage system 100 according to embodiments of this application.

The energy storage system 100 includes one or more battery clusters 110 and an enclosure 120.

Each battery cluster 110 includes a plurality of battery cells 1111, a dimension of the battery cluster 110 along a first direction being greater than a dimension of the battery cluster 110 along a second direction.

The enclosure 120 is configured to accommodate the battery clusters 110, a dimension of the enclosure 120 along the first direction being smaller than a dimension of the enclosure 120 along the second direction.

Along the first direction, the dimension of the enclosure 120 matches the dimension of the battery cluster 110, such that the enclosure 120 is configured to accommodate one row of battery clusters 110 along the first direction, the first direction is perpendicular to the second direction, and both the first direction and the second direction are perpendicular to a height direction of the enclosure.

The height direction of the enclosure 120 refers to a direction of the height of the enclosure 120 when the energy storage system 100 is placed on the ground for use. For example, the enclosure 120 may be cuboidal, and the direction of the height of the enclosure 120 is the height direction of the enclosure 120. As shown in FIG. 1, a direction perpendicular to the paper surface may be the height direction of the enclosure 120.

The first direction and the second direction may respectively be a width direction and a length direction of the enclosure 120, and the first direction and the second direction may respectively be a length direction and a width direction of the battery cluster 110. That is, a long side of the battery cluster 110 may be parallel to a wide side of the enclosure 120.

Along the first direction, the dimension of the enclosure 120 matching the dimension of the battery cluster 110 means that along the first direction, the dimension of the enclosure 120 is slightly greater than or equal to the dimension of the battery cluster 110, such that the enclosure 120 is configured to accommodate one row of battery clusters 110 along the first direction.

Along the first direction, the dimension of the battery cluster 110 should account for the dimension of the battery cluster 110 itself and the space occupied by external wiring of the battery cluster 110. For example, along the first direction, the dimension of the battery cluster 110 is a, and the dimension of the enclosure 120 may also be a. As another example, the dimension of the battery cluster 110 is b, and the dimension of the enclosure 120 may be 1.1b. The dimension of the enclosure 120 along the first direction shall not exceed twice the dimension of the battery cluster 110 along the first direction.

For example, as shown in FIG. 1, along the first direction, the dimension of the enclosure 120 is slightly greater than the dimension of the battery cluster 110.

The number of battery clusters 110 in one row placed along the first direction may be one or more. For example, as shown in FIG. 1, one row is placed along the first direction, and four columns are placed along the second direction. Alternatively, one row may be placed along the first direction, and one column may be placed along the second direction.

In the embodiments of this application, along the first direction, the dimension of the enclosure 120 is configured to match the dimension of the battery cluster 110, allowing the enclosure 120 to accommodate one row of battery clusters 110 along the first direction. In addition, the enclosure 120 can accommodate only one row of elongated battery clusters 110 along the first direction by arranging a long side of the battery cluster 110 parallel to a short side of the enclosure 120, thereby improving the space utilization of the enclosure 120.

In some embodiments of this application, the battery cluster 110 includes one or more battery modules 111 stacked along the height direction, each battery module 111 including one or more battery cells 1111.

For example, one battery cluster 110 may include four battery modules 111 stacked along the height direction, each battery module 111 including twelve battery cells 1111, as shown in FIG. 2.

The arrangement of the battery cells 1111 in the battery module 111 may include various configurations. As one example, as shown in FIG. 2, two rows are stacked along the height direction, with each row having six cuboidal battery cells 1111 arranged sequentially along the second direction. As another example, the plurality of battery cells 1111 in the battery module 111 are stacked only along the height direction; for instance, the battery module 111 includes ten cuboidal battery cells 1111, where the ten battery cells 1111 are stacked along the height direction, and the ten battery cells 1111 are elongated battery cells.

Of course, in the embodiments of this application, the shape of the battery cells 1111 may also be cubic or cylindrical.

Since the battery cluster 110 includes one battery module 111 or a plurality of battery modules 111 stacked along the height direction, the dimensions of the battery module 111 along the first direction and the second direction are the same as or close to the dimensions of the battery cluster 110. The dimension of the battery module 111 along the first direction is greater than the dimension of the battery module 111 along the second direction, and along the first direction, the dimension of the enclosure 120 matches the dimension of the battery module 111, such that the enclosure 120 is configured to accommodate one row of battery modules 111 along the first direction.

In the energy storage system 100, the number of battery modules 111 in the plurality of battery clusters 110 may be the same or different. Similarly, the number of battery cells 1111 in the plurality of battery modules 111 may be the same or different.

In the embodiments of this application, a battery cluster 110 including one battery module 111 or a plurality of battery modules 111 stacked along the height direction is provided, which allows the enclosure 120 to accommodate one row of battery modules 111 along the first direction, with a long side of the battery module 111 being parallel to a short side of the enclosure 120, thereby allowing the enclosure 120 to accommodate exactly one row of elongated battery modules 111 along the first direction, improving the space utilization of the enclosure 120.

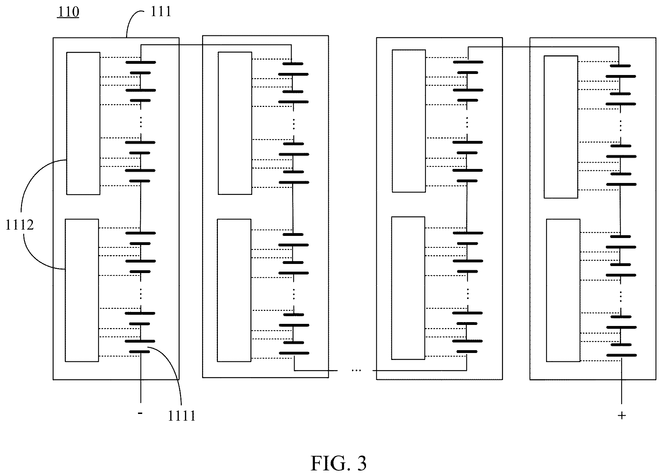

In some embodiments of this application, as shown in FIG. 3, the battery cells 1111 in the battery module 111 are connected in series.

That is, when a battery module 111 includes a plurality of battery cells 1111, the plurality of battery cells 1111 are connected in series.

In the embodiments of this application, the requirement for the overcurrent capacity of electrical components in the battery module 111 can be lowered by connecting the battery cells 1111 in the battery module 111 in series, while the number of battery cells 1111 in the battery module 111 can be increased.

In some embodiments of this application, as shown in FIG. 3, the battery modules 111 in the battery cluster 110 may be connected in series.

That is, In the embodiments of this application, when a battery cluster 110 includes a plurality of battery modules 111, the plurality of battery modules 111 are connected in series.

For example, as shown in FIG. 3, the battery cluster 110 includes a plurality of battery modules 111, each battery module 111 including a plurality of battery cells 1111. The battery cells 1111 in each battery module 111 are connected in series, and the plurality of battery modules 111 are also connected in series. Therefore, all the battery cells 1111 in the battery module 110 are connected in series.

In some embodiments of this application, as shown in FIG. 3, the battery module 111 includes a slave control unit 1112, where the slave control unit 1112 is connected to the battery cells 1111 of the battery module 111 and configured to collect state information of the battery cells 1111 in the battery module 111, the state information including one or more of current information, voltage information, power information, or state of charge (state of charge, SOC) information.

In the embodiments of this application, one or more state information of the battery cells 1111 such as current information, voltage information, power information, or SOC information are collected, then the state information of the battery module 111, battery cluster 110, or energy storage system 100 can be determined based on the state information of the battery cells, thereby enabling reasonable control of the charging and discharging processes of the energy storage system 100, enhancing the performance and lifespan of the energy storage system 100.

In some embodiments of this application, the battery module 111 includes 104 battery cells 111.

For example, the battery module 111 may include 104 lithium iron phosphate battery cells, the 104 lithium iron phosphate battery cells being connected in series.

In the embodiments of this application, the provision of 104 battery cells 1111 in the battery module 111 increases the number of battery cells 1111 in the battery module 111.

In some embodiments of this application, the battery module 111 includes two slave control units 1112, where the two slave control units 1112 are configured to respectively collect state information of a first group of battery cells and a second group of battery cells among the 104 battery cells 1111, and the number of battery cells in the first group or the second group does not exceed 56.

Currently, a slave control unit 1112 can typically support the collection of state information of up to 56 battery cells 1111. Therefore, two slave control units 1112 may be provided in a battery module 111 including 104 battery cells 1111. The 104 battery cells 1111 are divided into two groups, one slave control unit 1112 is configured to collect state information of one group of battery cells, and the other slave control unit 1112 is configured to collect state information of the other group of battery cells.

For example, the number of battery cells in the first group may be 56, and the number of battery cells 1111 in the second group may be 48. For another example, the number of battery cells in both the first group and the second group may be 52.

Various communication methods between the slave control units 1112 can be supported, such as communication in a daisy chain manner or via a controller area network (controller area network, CAN).

In the embodiments of this application, the state information of the battery cells 1111 in the battery module 111 can be comprehensively and accurately collected by providing two slave control units 1112 in the battery module 111 including 104 battery cells 1111, thereby enabling precise control of the charging and discharging of the energy storage system 100, improving the performance and lifespan of the energy storage system 100.

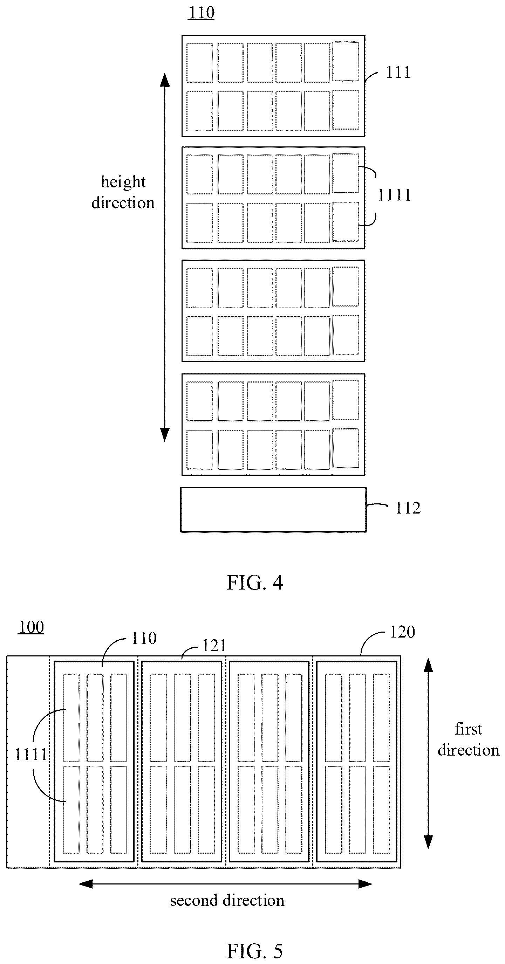

In some embodiments of this application, as shown in FIG. 4, the battery cluster 110 further includes a master control box 112, the master control box 112 being configured for energy transmission of the battery cluster 110.

The master control box 112 may be configured to house electrical components of the battery cluster 110. One end of the master control box 112 may be connected to a bus, and the other end of the master control box 112 may be connected to the battery modules 111 in the battery cluster 110. The battery modules 111 are connected to the bus through the master control box 112, thereby enabling energy transmission between the battery cluster 110 and the bus.

In the embodiments of this application, the master control box 112 provided in the battery cluster 110 may be configured to house electrical components of the battery cluster 110, facilitating maintenance and management of the electrical components in the battery cluster 110.

In some embodiments of this application, the enclosure 120 further includes a plurality of compartments 121 arranged along the second direction, where the plurality of compartments 121 includes a first compartment, the first compartment being configured to accommodate at least one of the plurality of battery clusters 110.

The first compartment is any one of the plurality of compartments 121.

For example, as shown in FIG. 5, the enclosure 120 is provided with four compartments 121 arranged along the second direction, the four compartments 121 being configured to accommodate the one row of battery clusters 110 along the first direction described above. The enclosure 120 accommodates battery clusters 110 arranged in one row along the first direction and four columns along the second direction, where the one row and four columns of battery clusters 110 are respectively accommodated in the four compartments 121.

The enclosure 120 is provided with a plurality of compartments 121 along the second direction, with one of the compartments 121 serving as the first compartment, the first compartment being configured to accommodate at least one battery cluster 110.

In this embodiment, the number of battery clusters 110 accommodated in the plurality of compartments 121 may be the same or different.

In the embodiments of this application a plurality of compartments 121 arranged along the second direction are provided in the enclosure 120, and at least one battery cluster 110 can be accommodated in one of the plurality of compartments 121, achieving reasonable allocation of space within the enclosure 120 and improving the space utilization of the enclosure 120.

In some embodiments of this application, the first compartment includes a plurality of sub-compartments 1211, the plurality of sub-compartments 1211 being stacked along the height direction and configured to accommodate battery modules 111 and the master control boxes 112 of the at least one battery cluster 110.

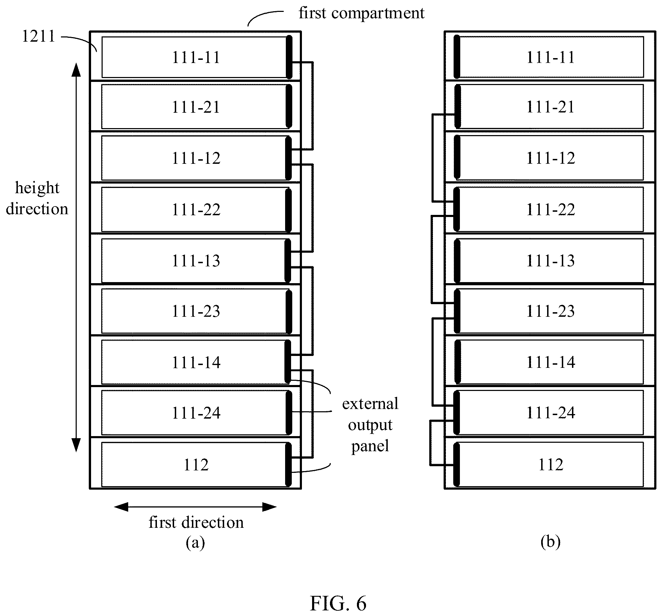

For example, FIG. 6 (a) and (b) show views of the first compartment from two sides along the second direction, where the first compartment is configured to accommodate battery modules 111 and master control boxes 112 of two battery clusters 110, one battery cluster 110 including battery modules 111-11 to 111-14 and a master control box 112, and the other battery cluster 110 including battery modules 111-21 to 111-24 and a master control box 112.

In the embodiments of this application, a plurality of sub-compartments 1211 stacked along the height direction are provided in the first compartment and configured to accommodate battery modules 111 and the master control box 112 of at least one battery cluster 110, achieving reasonable utilization of space within the first compartment, improving the space utilization of the first compartment, and thereby improving the space utilization of the enclosure 120.

In some embodiments of this application, external output panels of the battery modules 111 of the at least one battery cluster 110 face a first side of the first direction, where the number of battery modules 111 in the at least one battery cluster 110 is greater than or equal to two.

The external output panel of the battery module 111 can be understood as the terminal of the battery module 111, for example, a terminal used for series connection between battery modules 111.

That is, in the first compartment, the external output panels of the battery modules 111 of the at least one battery cluster 110 face a same direction along the first direction. For example, as shown in FIG. 6, in the first compartment, the number of the at least one battery cluster 110 is two, and the external output panels of the battery modules 111 of the two battery clusters 110 face a same side of the first direction.

In the embodiments of this application, installation and maintenance of the battery cluster 110 are facilitated by configuring the external output panels of the battery modules 111 in the first compartment to face the same direction, improving the efficiency of installation and maintenance of the battery cluster 110, while also enabling reasonable utilization of the space of the enclosure 120, improving the space utilization of the enclosure 120.

In some embodiments of this application, the at least one battery cluster 110 includes one master control box 112, where one end of the master control box 112 is connected to the battery modules 111 of the at least one battery cluster 110, and the other end of the master control box 112 is connected to a bus 200.

As an example, the number of the at least one battery cluster 110 is one, where the one battery cluster 110 includes one master control box 112, one end of the master control box 112 is connected to the battery modules 111 of the one battery cluster 110, and the other end of the master control box 112 is connected to the bus 200.

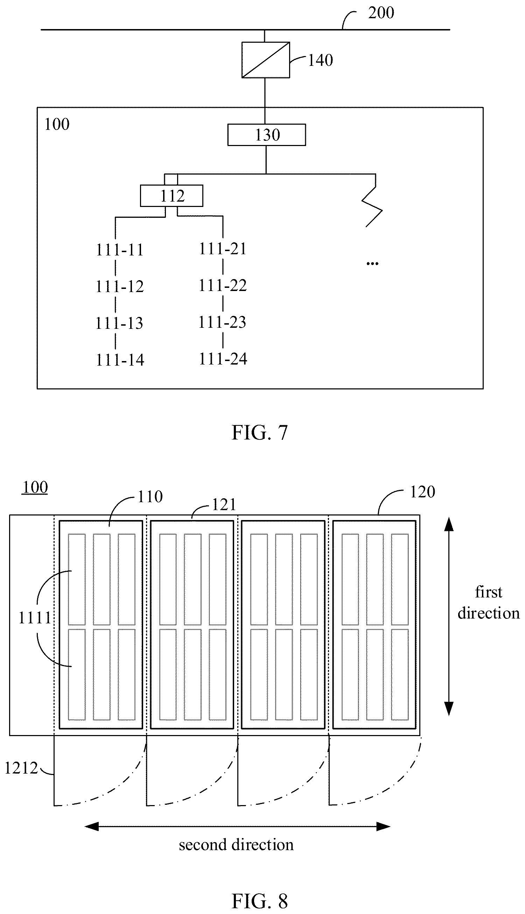

As an example, the number of the at least one battery cluster 110 is more than one, the multiple battery clusters 110 sharing one master control box 112. The one master control box 112 may include multiple direct current transmission circuits, respectively configured for energy transmission of the multiple battery clusters 110. For example, as shown in FIG. 6 and FIG. 7, the number of the at least one battery cluster 110 is two, and each battery cluster 110 includes four battery modules 111. That is, one battery cluster 110 includes battery modules 111-11 to 111-14, and the other battery cluster 110 includes battery modules 111-21 to 111-24. The two battery clusters 110 collectively include one master control box 112, one end of the master control box 112 may be connected to the battery modules 111 of the two battery clusters 110, and the other end of the master control box 112 may be connected to the bus.

In some embodiments of this application, the other end of the master control box 112 may be connected to the bus 200 through a busbar apparatus 130. That is, a busbar apparatus 130 is further provided between the master control box 112 and the bus 200. For example, the other end of the master control box 112 of the battery cluster 110 is connected to one end of the busbar apparatus 130, and the other end of the busbar apparatus 130 is connected to the bus 200.

In some embodiments of this application, a converter apparatus 140 is further provided between the busbar apparatus 130 and the bus 200. The converter apparatus 140 may be a bidirectional converter apparatus, such as a power conversion system (power conversion system, PCS), to enable energy input or output of the energy storage system 100.

In the embodiments of this application, the at least one battery cluster 110 in the first compartment may include one master control box 112, and the master control box 112 is configured for energy transmission of the at least one battery cluster 110, so that the space occupied by the master control box 112 in the first compartment can be reduced, thereby improving the space utilization of the enclosure 120 or reducing the volume of the enclosure 120.

In some embodiments of this application, one battery cluster 110 among the at least one battery cluster 110 includes one master control box 112.

For example, in the energy storage system 100, each battery cluster 110 includes one master control box 112.

In the embodiments of this application, each battery cluster 110 includes one master control box 112, so energy transmission of each battery cluster 110 can be flexibly achieved while facilitating installation and maintenance of each battery cluster 110 in the first compartment, improving the efficiency of installation and maintenance of the battery cluster 110.

In some embodiments of this application, a door 1212 is provided at a portion of the enclosure 120 corresponding to the first compartment on the first side.

That is, a door 1212 is provided at a portion of the enclosure 120 corresponding to the first compartment on the side of the external output panels of the battery modules 111 of the at least one battery cluster 110.

In some embodiments, as shown in FIG. 8, a door 1212 is provided at respective portions of the enclosure 120 corresponding to the plurality of compartments 121 on the same side of the first direction. That is, the enclosure 120 may be provided with four doors 1212, the four doors 1212 facing the same side of the first direction.

Of course, the orientations of the four doors 1212 of the enclosure 120 may alternatively be different. For example, two doors 1212 face one side of the first direction, and the other two doors 1212 face the other side of the first direction.

As one example, the first compartment may include a plurality of battery clusters 110, where the plurality of battery clusters 110 share one master control box 112, and external output panels of the battery modules 111 and the one master control box 112 of the plurality of battery clusters 110 face a same direction, all facing a side of the enclosure 120 provided with the door 1212.

As another example, the first compartment may include a plurality of battery clusters 110, where each battery cluster 110 includes one master control box 112, that is, the first compartment includes a plurality of master control boxes 112. The external output panels of the battery modules 111 and the master control boxes 112 of the plurality of battery clusters 110 face a same direction, all facing a side of the enclosure 120 provided with the door 1212.

In the embodiments of this application, a door 1212 is provided at the portion of the enclosure 120 corresponding to the first compartment on the side of the external output panels of the battery modules 111 of the at least one battery cluster 110 to facilitate installation and maintenance of the battery cluster 110, improving the efficiency of installation and maintenance of the battery cluster 110.

In some embodiments of this application, the external output panels of the battery modules 111 of the at least one battery cluster 110 face two sides of the first direction, where the external output panels of the battery modules 111 of the same battery cluster 110 face a same direction, and the number of the at least one battery cluster 110 is greater than or equal to two.

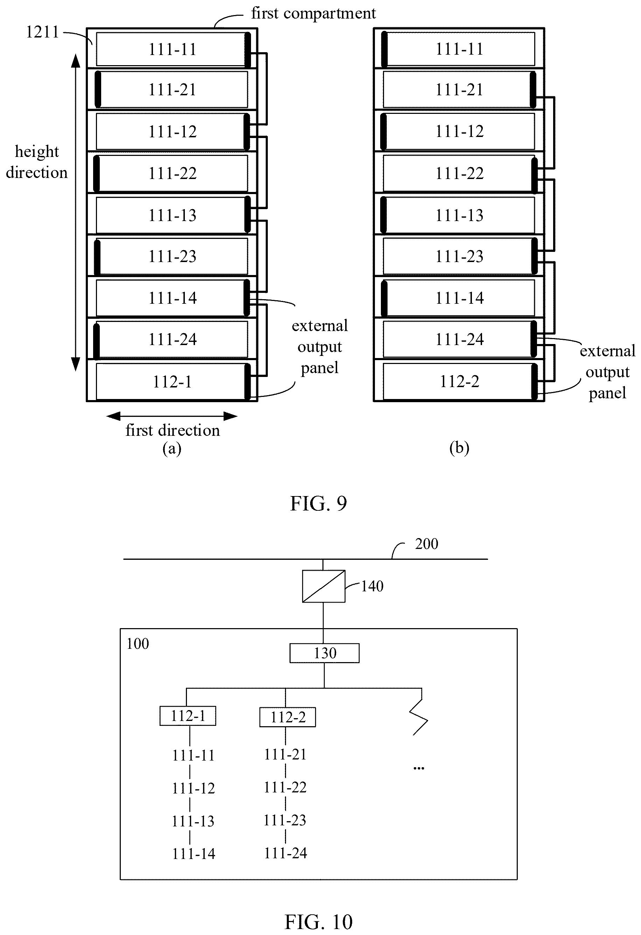

The external output panels of the battery modules 111 in each battery cluster 110 face a same direction, while the external output panels of the battery modules 111 of different battery clusters 110 face different directions. For example, FIG. 9 is a diagram of a first compartment from two sides along the second direction. In the first compartment, the number of the at least one battery cluster 110 is two, one of the two battery clusters 110 includes battery modules 111-11 to 111-14, and the other battery cluster 110 includes battery modules 111-21 to 111-24. The external output panels of the battery modules 111-11 to 111-14 face one side of the first direction, and the external output panels of the battery modules 111-21 to 111-24 face the other side of the first direction.

In the embodiments of this application, the orientation of the battery modules 111 in the first compartment can be flexibly arranged by configuring the output panels of the battery modules 111 in the first compartment to face two sides of the first direction, while also facilitating installation and maintenance of each battery cluster 110 in the first compartment, improving the efficiency of installation and maintenance of the battery cluster 110.

In some embodiments of this application, one battery cluster 110 among the at least one battery cluster 110 includes one master control box 112, where one end of the one master control box 112 is connected to the battery modules 111 of the one battery cluster 110, and the other end of the one master control box 112 is connected to a bus 200.

For example, as shown in FIG. 9 and FIG. 10, one battery cluster 110 includes a master control box 112-1, and the other battery cluster 110 includes a master control box 112-2. One end of the master control box 112-1 is connected to the battery module 111-14 of the one battery cluster 110, and the other end of the master control box 112-1 is connected to the bus 200. One end of the master control box 112-2 is connected to the battery module 111-24 of the other battery cluster 110, and the other end of the master control box 112-2 is connected to the bus 200.

In the embodiments of this application, each battery cluster 110 in the first compartment may include one master control box 112, and the one master control box 112 may be configured for energy transmission of the one battery cluster 110, facilitating installation and maintenance of each battery cluster 110 in the first compartment, and improving the efficiency of installation and maintenance of the battery cluster 110.

In some embodiments of this application, doors 1212 are provided at portions of the enclosure 120 corresponding to the first compartment on two sides of the first direction.

The number of the at least one battery cluster 110 in the first compartment is greater than or equal to two.

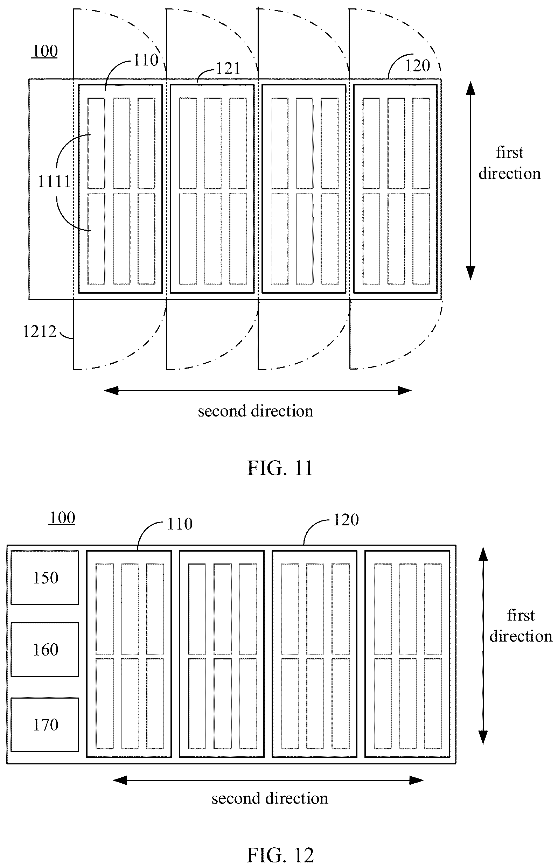

That is, in the first compartment, the external output panels of the battery modules 111 of the at least one battery cluster 110 face two sides of the first direction, and doors 1212 are provided at portions of the enclosure 120 corresponding to the first compartment on two sides of the first direction. For example, as shown in FIG. 11, the enclosure 120 includes four compartments, and doors 1212 are provided at portions of the enclosure 120 corresponding to each compartment on two sides of the first direction.

In the embodiments of this application, doors 1212 are provided at portions of the enclosure 120 corresponding to the first compartment on two sides of the first direction, facilitating installation and maintenance of each battery cluster 110 in the first compartment, and improving the efficiency of installation and maintenance of the battery cluster 110.

In some embodiments of this application, the enclosure 120 includes a plurality of compartments 121, for example, including a first compartment and a second compartment, a door is provided at the portion of the enclosure 120 corresponding to the first compartment on one side of the first direction, and doors are provided at portions of the enclosure 120 corresponding to the second compartment on two sides of the first direction.

In some embodiments of this application, in the at least one battery cluster 110, an external output panel of a master control box 112 of one battery cluster 110 faces a same direction as the external output panels of the battery modules 111 of the one battery cluster 110.

That is, in the first compartment, the master control box 112 of each battery cluster 110 faces a same direction as the external output panels of the battery modules 111 of the battery cluster 110, as shown in FIG. 6 or FIG. 9.

In the embodiments of this application, the external output panels of the master control box 112 and the battery modules 111 of one battery cluster 110 are configured to face a same direction, facilitating installation and maintenance of the battery cluster 110 while improving the space utilization of the enclosure 120.

In some embodiments of this application, the energy storage system includes eight battery clusters 110, the enclosure 120 includes four compartments 121 arranged along the second direction, and one of the four compartments 121 is configured to accommodate two of the eight battery clusters 110.

As shown in FIG. 5, the enclosure 120 is provided with four compartments 121 along the second direction. Each compartment 121 may be configured to accommodate two battery clusters 110.

In the embodiments of this application, four compartments 121 arranged along the second direction are provided in the enclosure 120, and at least two battery clusters 110 can be accommodated in one of the four compartments 121, achieving reasonable allocation of space within the enclosure 120 and improving the space utilization of the enclosure 120.

In some embodiments of this application, each of the eight battery clusters 110 includes four battery modules 111, one compartment 121 includes nine sub-compartments 1211 stacked along the height direction, the lowermost sub-compartment 1211 of the nine sub-compartments 1211 is configured to accommodate the master control boxes 112 of the two battery clusters 110, and the remaining sub-compartments 1211 of the nine sub-compartments 1211 are respectively configured to accommodate the eight battery modules 111 of the two battery clusters 110, where battery modules 111 accommodated in adjacent sub-compartments 1211 belong to different battery clusters 110, as shown in FIG. 6 or FIG. 9.

That is, in the embodiments of this application, in one compartment 121, the master control boxes 111 of the two battery clusters 110 are accommodated in the lowermost sub-compartment 1211 of the compartment 121, and the eight battery modules 111 of the two battery clusters 110 are stacked in the remaining eight sub-compartments 1211, with battery modules 111 in adjacent sub-compartments belonging to different battery clusters 110.

In the embodiments of this application, reasonable utilization of space within the compartment 121 is achieved by providing nine sub-compartments 1211 stacked along the height direction in the first compartment, configured to accommodate the battery modules 111 and the master control boxes 112 of two battery clusters 110, improving the space utilization of the compartment 121, and thereby improving the space utilization of the enclosure 120.

In some embodiments of this application, the external output panels of the battery modules 111 of the two battery clusters 110 face a side of the first direction, the two battery clusters 110 include one master control box 112, the external output panels of the battery modules 111 of the two battery clusters 110 and the external output panel of the one master control box 112 face a same direction, and the one master control box 112 is configured for energy transmission of the two battery clusters 110, as shown in FIG. 6.

In the embodiments of this application, in one compartment 121, the external output panels of the battery modules 111 and the master control box 112 of the two battery clusters 110 are configured to face the same direction, facilitating installation and maintenance of the battery clusters 110 in the compartment 121 and improving the efficiency of installation and maintenance of the battery clusters 110, while also enabling reasonable utilization of the space of the enclosure 120, improving the space utilization of the enclosure 120.

In some embodiments of this application, the external output panels of the battery modules 111 of the two battery clusters 110 face two sides of the first direction, each of the two battery clusters 110 includes one master control box 112, and the external output panels of the battery modules 111 and the master control box 112 of each of the two battery clusters 110 face a same direction, as shown in FIG. 9.

In the embodiments of this application, the output panels of the battery modules 111 in one compartment 121 are configured to face two sides of the first direction, which allows flexible arrangement of the orientation of the battery modules 111 in the compartment 121 while facilitating installation and maintenance of each battery cluster 110 in the compartment 121, improving the efficiency of installation and maintenance of the battery cluster 110.

In some embodiments of this application, as shown in FIG. 12, the energy storage system 100 further includes one or more of the following: a thermal management apparatus 150 configured to regulate a temperature of the energy storage system 100; a fire protection apparatus 160 configured to perform detection, alarm, or fire suppression for the energy storage system 100; and a power distribution apparatus 180 configured to distribute power to electrical equipment of the energy storage system 100; where one or more of the thermal management apparatus 150, the fire protection apparatus 160, or the power distribution apparatus 170 are disposed on one side of the enclosure along the second direction.

The thermal management apparatus 150 can decrease the temperature of the energy storage system 100 when the temperature is too high, and increase the temperature of the energy storage system 100 when the temperature is too low. For example, the thermal management apparatus 150 may include a heating module and a cooling module, where the heating module or cooling module is configured to heat or cool a fluid in a fluid circulation circuit, and the fluid then exchanges heat with the battery cluster 110 to regulate the temperature of the energy storage system 100. The fluid circulation circuit may be disposed around the battery cluster 110.

The fire protection apparatus 160 may integrate detection, alarm, and fire suppression functions, for example, by real-time monitoring of the operating temperature of the energy storage system 110, whether smoke is generated, and the like, to determine whether there is a possibility of a fire in the energy storage system 110. When a potential fire is detected in the energy storage system 110, the fire protection apparatus 160 may promptly issue an alarm and take preemptive fire suppression measures.

The power distribution apparatus 170 may be configured to distribute power to electric device in the energy storage system 100, such as the thermal management module.

For example, as shown in FIG. 12, the thermal management apparatus 150, the fire protection apparatus 160, and the power distribution apparatus 170 are disposed on the left side of the enclosure 120 along the second direction, and the thermal management apparatus 150, the fire protection apparatus 160, and the power distribution apparatus 170 are arranged along the first direction.

In the embodiments of this application, one or more of the thermal management apparatus 150, the fire protection apparatus 160, and the power distribution apparatus 170 are disposed on one side of the enclosure 120 along the second direction, improving the space utilization of the enclosure 120.

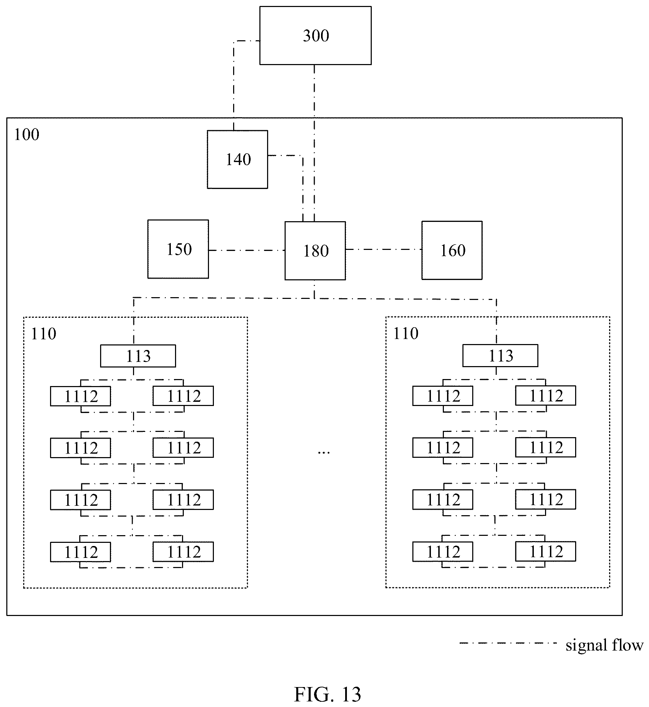

In some embodiments of this application, as shown in FIG. 13, the battery cluster 110 further includes a master control unit 113, one end of the master control unit 113 being connected to the slave control unit 1112 and configured to communicate with the slave control unit.

For example, the slave control unit 1112 in one battery cluster 110 may send collected state information of the battery cells 1111 to the master control unit 113, enabling the master control unit 113 to determine the state information of the battery cluster 110 based on the state information of the battery cells 1111.

The state information of the battery cluster 110 may include one or more of current information, voltage information, power information, or state of charge SOC information of the battery cluster 110.

In the embodiments of this application, the master control unit 113 is connected to the slave control unit 1112, allowing acquisition of the state information of the battery cells 110 in the battery cluster 110, thereby enabling accurate determination of the state information of the battery cluster 110.

In some embodiments of this application, as shown in FIG. 13, the energy storage system 100 further includes: a main control unit 180, the main control unit 150 being connected to the master control unit 113, and configured to communicate with the master control unit 113.

For example, the master control unit 112 may send the state information of the battery cluster 110 to the main control unit 180, and the main control unit 180 may determine the state information of the energy storage system 100 based on the state information sent by the master control units 112 of the respective battery clusters 110.

The state information of the energy storage system 100 may include one or more of current information, voltage information, power information, or state of charge SOC information of the battery clusters 110.

In some embodiments of this application, the main control unit 180 may serve as a battery management unit of the energy storage system 100 and be configured to monitor and manage the energy storage system 100, for example, monitoring information such as current, voltage, power, or temperature of the energy storage system 100. For example, it may control the charging and discharging current, voltage, and the like of the energy storage system 100.

In some embodiments of this application, the master control unit 113 may serve as a battery management unit of the battery cluster 110, configured to monitor and manage the battery cluster 110. It may monitor information such as current, voltage, power, or temperature of the battery cluster 110. For example, it may control the charging and discharging current, voltage, and the like of the battery cluster 110.

In some embodiments of this application, a master control unit 113 of a battery cluster 110 may be placed in a master control box 112 corresponding to the battery cluster 110. For example, as described above, the master control box 112 may house electrical components of the battery cluster 110 for energy transmission of the battery cluster 110; and the master control box 112 may also house the master control unit 113 of the battery cluster 110 for controlling the energy transmission of the battery cluster 110.

In some embodiments of this application, the main control unit 180 may also be connected to an energy management unit 300, such as an energy management system (energy management system, EMS), for communication with the energy management unit 300.

In some embodiments of this application, the main control unit 180 may also be connected to the thermal management apparatus 150. The main control unit 180 may be configured to control the thermal management apparatus 150 to perform heating or cooling.

In some embodiments of this application, the main control unit 180 may also be connected to the fire protection apparatus 160. The main control unit 180 may be configured to monitor the operating state of the fire protection apparatus 180, such as detection state, alarm state, or fire suppression state.

In the embodiments of this application, the main control unit 180 is connected to the master control unit 150, allowing acquisition of the state information of the battery clusters 110 in the energy storage system 100 to determine the state information of the energy storage system 100, thereby allowing reasonable control of the charging and discharging processes of the energy storage system 100.

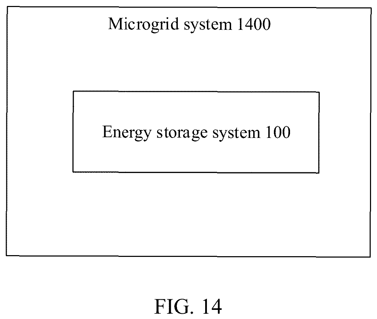

FIG. 14 is a schematic block diagram of a microgrid system 1400 according to embodiments of this application, the microgrid system 1400 including the energy storage system 100 provided by embodiments of this application.

The details of the energy storage system 100 can be referred to in the relevant descriptions above, and are not repeated herein.

Although this application has been described with reference to preferred embodiments, various modifications may be made thereto, and equivalents may be substituted for components thereof without departing from the scope of this application. In particular, as long as there is no structural conflict, the technical features mentioned in the various embodiments may be combined in any manner. This application is not limited to the specific embodiments disclosed herein but includes all technical solutions falling within the scope of the claims.

## Claims

1. An energy storage system, **characterized by** comprising:
one or more battery clusters, wherein each battery cluster comprises a plurality of battery cells, and a dimension of the battery cluster along a first direction is greater than a dimension of the battery cluster along a second direction; and
an enclosure configured to accommodate the battery clusters, a dimension of the enclosure along the first direction being smaller than a dimension of the enclosure along the second direction;
wherein along the first direction, the dimension of the enclosure matches the dimension of the battery cluster, such that the enclosure is configured to accommodate one row of battery clusters along the first direction, the first direction is perpendicular to the second direction, and both the first direction and the second direction are perpendicular to a height direction of the enclosure.

2. The energy storage system according to claim 1, **characterized in that** the battery cluster comprises one or more battery modules stacked along the height direction, each battery module comprising one or more battery cells.

3. The energy storage system according to claim 2, **characterized in that** the battery cells in the battery module are connected in series.

4. The energy storage system according to claim 2 or 3, **characterized in that** the battery module further comprises a slave control unit, wherein the slave control unit is connected to the battery cells of the battery module and configured to collect state information of the battery cells in the battery module, the state information comprising one or more of current information, voltage information, power information, or state of charge SOC information.

5. The energy storage system according to claim 4, **characterized in that** the battery module comprises 104 battery cells.

6. The energy storage system according to claim 5, **characterized in that** the battery module comprises two slave control units, wherein the two slave control units are configured to respectively collect state information of a first group of battery cells and a second group of battery cells among the 104 battery cells, and the number of battery cells in the first group or the second group does not exceed 56.

7. The energy storage system according to any one of claims 1 to 6, **characterized in that** the battery cluster further comprises a master control box, the master control box being configured for energy transmission of the battery cluster.

8. The energy storage system according to any one of claims 1 to 7, **characterized in that** the enclosure comprises a plurality of compartments arranged along the second direction, wherein the plurality of compartments comprises a first compartment, the first compartment being configured to accommodate at least one of the plurality of battery clusters.

9. The energy storage system according to claim 8, **characterized in that** the first compartment comprises a plurality of sub-compartments, wherein the plurality of sub-compartments are stacked along the height direction and respectively configured to accommodate battery modules and a master control box of the at least one battery cluster.

10. The energy storage system according to claim 9, **characterized in that** external output panels of the battery modules of the at least one battery cluster face a first side of the first direction, wherein the number of battery modules in the at least one battery cluster is greater than or equal to two.

11. The energy storage system according to claim 10, **characterized in that** the at least one battery cluster comprises one master control box, wherein one end of the master control box is connected to the battery modules of the at least one battery cluster, and the other end of the master control box is connected to a bus.

12. The energy storage system according to claim 10, **characterized in that** one battery cluster of the at least one battery cluster comprises one master control box, wherein one end of the master control box is connected to the battery modules of the one battery cluster, and the other end of the master control box is connected to a bus.

13. The energy storage system according to any one of claims 10 to 12, **characterized in that** a door is provided at a portion of the enclosure corresponding to the first compartment on the first side.

14. The energy storage system according to claim 9, **characterized in that** the external output panels of the battery modules of the at least one battery cluster face two sides of the first direction, wherein external output panels of the battery modules of a same battery cluster face a same direction, and the number of the at least one battery cluster is greater than or equal to two.

15. The energy storage system according to claim 14, **characterized in that** one battery cluster among the at least one battery cluster comprises one master control box, wherein one end of the master control box is connected to the battery modules of the one battery cluster, and the other end of the master control box is connected to a bus.

16. The energy storage system according to claim 15, **characterized in that** doors are provided at portions of the enclosure corresponding to the first compartment on two sides of the first direction.

17. The energy storage system according to any one of claims 8 to 16, **characterized in that** the external output panels of the master control box and the battery modules of one battery cluster among the at least one battery cluster face a same direction.

18. The energy storage system according to any one of claims 1 to 17, **characterized in that** the energy storage system comprises eight battery clusters, the enclosure comprises four compartments arranged along the second direction, and one of the four compartments is configured to accommodate two battery clusters of the eight battery clusters.

19. The energy storage system according to claim 18, **characterized in that** each of the eight battery clusters comprises four battery modules, one compartment comprises nine sub-compartments stacked along the height direction, the lowermost sub-compartment of the nine sub-compartments is configured to accommodate master control boxes of the two battery clusters, and the remaining sub-compartments of the nine sub-compartments are respectively configured to accommodate the eight battery modules of the two battery clusters, wherein battery modules accommodated in adjacent sub-compartments belong to different battery clusters.

20. The energy storage system according to claim 19, **characterized in that** the external output panels of the battery modules of the two battery clusters face a side of the first direction, the two battery clusters comprise one master control box, the external output panels of the battery modules of the two battery clusters and an external output panel of the one master control box face a same direction, and the one master control box is configured for energy transmission of the two battery clusters.

21. The energy storage system according to claim 19, **characterized in that** the external output panels of the battery modules of the two battery clusters face two sides of the first direction, each of the two battery clusters comprises one master control box, and the external output panels of the battery modules and the master control box of each of the two battery clusters face the same direction.

22. The energy storage system according to any one of claims 1 to 21, **characterized in that** the energy storage system further comprises one or more of the following:
a thermal management apparatus configured to regulate a temperature of the energy storage system;
a fire protection apparatus configured to perform detection, alarm, or fire suppression for the energy storage system; and
a power distribution apparatus configured to distribute power to electrical equipment of the energy storage system;
wherein one or more of the thermal management apparatus, the fire protection apparatus, or the power distribution apparatus are disposed on one side of the enclosure along the second direction.

23. The energy storage system according to any one of claims 4 to 22, **characterized in that** the battery cluster further comprises a master control unit, the master control unit being connected to the slave control unit and configured to communicate with the slave control unit.

24. The energy storage system according to claim 23, **characterized in that** the energy storage system further comprises:
a main control unit, the main control unit being connected to the master control unit and configured to communicate with the master control unit.

25. A microgrid system, comprising the energy storage system according to any one of claims 1 to 24.
